(19) Europäisches Patentamt
European Patent Office
Office européen des brevets

(11) Veröffentlichungsnummer: **0 319 810 A2**

(12) **EUROPÄISCHE PATENTANMELDUNG**

(21) Anmeldenummer: **88119744.6**

(51) Int. Cl.4: **H03K 17/73**

(22) Anmeldetag: **26.11.88**

(30) Priorität: **08.12.87 CH 4794/87**

(43) Veröffentlichungstag der Anmeldung: **14.06.89 Patentblatt 89/24**

(84) Benannte Vertragsstaaten: **AT BE DE FR GB IT LU NL SE**

(71) Anmelder: **ZELLWEGER USTER AG**
**Wilstrasse 11**
**CH-8610 Uster(CH)**

(72) Erfinder: **Hobi, Günther**
**Obermülistrasse 47**
**CH-8320 Fehraltorf(CH)**

# (54) Ansteuerschaltung für einen GTO-Thyristor.

(57) Die Schaltung enthält eine getrennte Zünd- und Löschschaltung (32, 33 bzw. 61, 62) mit je einem kapazitiven Ladungsspeicher (28, 29 bzw. 30, 31) für die Erzeugung der Zünd- und der Löschstromimpulse. Es ist ein direkt über eine Gegentaktstufe (34 bzw. 60) ansteuerbares schnelles Schaltelement (32 bzw. 61) vorgesehen, welches bei seiner Ansteuerung den jeweiligen Ladungsspeicher über den Gate-Kathodenpfad (6, 7) des GTO-Thyristors entlädt.

Dadurch kann der GTO-Thyristor mit einer hohen Taktfrequenz bis mindestens 12 000 Hz betrieben und kann in Tonfrequenzsendern für Rundsteueranlagen verwendet werden.

FIG. 3

EP 0 319 810 A2

## Ansteuerschaltung für einen GTO-Thyristor

Die vorliegende Erfindung liegt auf dem Gebiet der Rundsteuerung. Diese ist bekanntlich ein System zur Uebermittlung von Schaltbefehlen über die bestehenden Verteilanlagen der Elektrizitätsversorgung und ermöglicht es, bei Lastspitzen oder Produktionsengpässen die Netzlast von einer zentralen Stelle aus direkt zu beeinflussen.

Eine zentrale Stellung in einer Rundsteueranlage nimmt der Sender ein, der die tonfrequenten Schaltsignale in das zu steuernde Netz sendet. Ein Kommandogerät übermittelt dem Rundsteuersender das Bitmuster der verlangten Sendung, und der Sender setzt dieses in ein Signal mit der entsprechenden Rundsteuerfrequenz um, welches durch eine Ankopplung ins Netz gespeist wird. Jeder angeschlossene Rundsteuerempfänger empfängt das Signal, decodiert es und schaltet eine bestimmte angeschlossene Last entsprechend.

Der Rundsteuersender kann für eine Funktionsbetrachtung in einen Steuer- und einen Leistungteil aufgeteilt werden. Der Steuerteil enthält alle zur Steuerung und Ueberwachung erforderlichen Schaltungen, der Leistungsteil enthält unter anderem Steuerungs- und Messumformer, Gleichrichter, Wechselrichter und einen Ausgangsteil. Führungseingangsgrössen lösen im Steuerteil Steuersignale aus, die im Leistungsteil in den Wechselrichterzweigen aus einer gleichgerichteten Spannung eine Lastspannung mit der gewünschten Rundsteuerfrequenz erzeugen.

Bisher ist der Leistungsteil in Form konventioneller Thyristorumrichter oder noch früher als Maschinenumformer realisiert worden. Aus dem reichen Schrifttum auf diesem Gebiet seien hier beispielsweise erwähnt: M. Meyer "Selbstgeführte Thyristorstromrichter", Siemens Fachbuch, 3. Auflage 1974; B.D. Bedford, R.G. Hoft "Principles of Inverter Circuits", John Wiley, New York 1964.

Maschinenumformer sind teuer und serviceintensiv und unterliegen mechanischen Abnützungserscheinungen. Ausserdem sind sie im allgemeinen nicht frequenzstabil. Sie benötigen eine längere Anlaufphase und erzeugen Lärm und Vibrationen.

Konventionelle Thyristorumrichter benötigen komplizierte Kommutierungseinrichtungen, da die Thyristoren nicht über die Steuerelektrode abschaltbar sind. Derartige Kommutierungseinrichtungen sind teuer, voluminös und schwer und sie müssen auf eine schmalbandige Frequenz ausgelegt werden. Die erforderlichen Drosselspulen erzeugen Lärm und die Kommutierung funktioniert nur in einem beschränkten Lastwinkelbereich. Ausserdem ist der Wirkungsgrad stark frequenz- und lastabhängig und liegt in der Regel unter 85%.

Seit einigen Jahren sind abschaltbare Thyristoren, sogenannte GTO-Thyristoren (GTO = Gate-Turn-Off) höherer Leistung für den Einsatz in Stromrichtern erhältlich, wodurch im Wechselrichterteil des Stromrichters die aufwendigen Kommutierungselemente nicht mehr benötigt werden. Sie werden durch eine Thyristor-Ein- und Ausschaltvorrichtung (Gatedriver) ersetzt, durch welche die Thyristoren über die Steuerelektrode (Gate) ein- und ausgeschaltet werden können. Dadurch steigt einerseits der Wirkungsgrad und anderseits wird das System praktisch lautlos, lastwinkelunabhängig, frei im Frequenzbereich, kleiner und leichter.

Bisherige Hauptanwendungsgebiete von GTO-Thyristoren sind Umrichter für industrielle Antriebe und Steuerungen, Wechselrichter in Hilfsstromversorgungsanlagen für den Schienen- und Strassenverkehr, Wechselrichter für Drehstomantriebe bei Schienenfahrzeugen und unterbrechungsfreie Stromversorgungsanlagen. Bei der Anwendung für Motorenantriebe liegt der benötigte Taktfrequenzbereich üblicherweise bei einigen 100 Hz; der maximale Frequenzbetrieb bisheriger Gatedriver liegt bei etwa 3000 Hz.

Rundsteuersender erfordern jedoch einen wesentlich höheren Frequenzbereich, da sie einen Frequenzbereich von ca. 100 - 2000 Hz abdecken müssen. Durch den Einsatz von 6-pulsigen Wechselrichterschaltungen mit einem Wechselrichter-Ausgangsstrom, dessen Strom-Zeit-Integral jeder Phase für jede Sendestromdauer gleich Null ist, wobei die Summe aller drei Ausgangsströme zu jedem Zeitpunkt ebenfalls gleich Null ist, benötigt man eine der sechsfachen Rundsteuerfrequenz entsprechende Taktfrequenz. Das bedeutet für eine 2000 Hz-Rundsteuerfrequenz eine Taktfrequenz von 12000 Hz für den GTO-Thyristor und den Gatedriver, dies ist ein Mehrfaches der bisher möglichen Maximalfrequenz.

Die Erfindung betrifft eine Ansteuerschaltung für einen mit hohen Taktfrequenzen betreibbaren GTO-Thyristor, mit einer separaten Zünd- und Löschschaltung.

Diese Ansteuerschaltung, die prinzipiell aus den Literaturstellen "Praxis mit dem GTO" von W. Bösterling, H. Ludwig, R. Schimmer, M. Tscharn, Sonderdruck aus "Elektrotechnik" 64 und 65, Heft 24, Dezember 1982, S. 16-21 und Heft 4, Februar 1983, S. 14-17; und "GTO-Gate-Circuit", Hitachi, Instruction Manual for Gate Circuit of Discrete Power Supply Systems, 12. April 1982, bekannt ist, soll für die Verwendung in Rundsteuersendern folgende Anforderungen erfüllen:

- Ermöglichung einer Taktfrequenz bis mindestens 12000 Hz.
- Lieferung der von GTO-Thyristoren geforderten speziellen Strom- und Spannungscharakteristiken.
Ermöglichung von schnellem Ein- und/oder Abschalten bei Notsituationen (Signallaufzeiten im Bereich von ca. 2 us und Energiereserven für Ein- und/oder Abschaltstromimpulse).
- Ermöglichung einer galvanischen Trennung zwischen Steuerlogik und Energieversorgung.

Die gestellte Aufgabe wird erfindungsgemäss dadurch gelöst, dass für die Erzeugung der Zünd- und des Löschstromimpulse je ein eigener kapazitiver Ladungsspeicher vorgesehen ist, und dass die Schaltung ein direkt über eine Gegentaktstufe ansteuerbares schnelles Schaltelement enthält, welches bei seiner Ansteuerung den jeweiligen Ladungsspeicher über den Gate-Kathoden- Pfad des GTO-Thyristors entlädt.

Die erfindungsgemässe Verwendung der beiden Ladungsspeicher für die Erzeugung des Zünd- und des Löschstromimpulses und des die Ladungsspeicher über den Gate-Kathoden-Pfad des GTO-Thyristors entladenden schnellen Schaltelements ermöglicht die geforderte hohe Taktfrequenz und das schnelle Ein- und/oder Ausschalten bei Notsituationen. Ebenso sind die geforderten Strom- und Spannungscharakteristiken und die galvanische Trennung zwischen Steuerlogik und Energieversorgung sichergestellt.

Im folgenden wird die Erfindung anhand eines in den Zeichnungen dargestellten Ausführungsbeispiels näher erläutert; es zeigt:

Fig. 1 ein Blockschema der Steuerschaltung eines GTO-Thyristors,

Fig. 2 ein Blockschema der Schutzbeschaltung eines GTO-Thyristors,

Fig. 3-5 je ein Blockschema des Gatedrivers der Schaltung von Fig. 1, und

Fig. 6,7 Diagramme zur Funktionserläuterung.

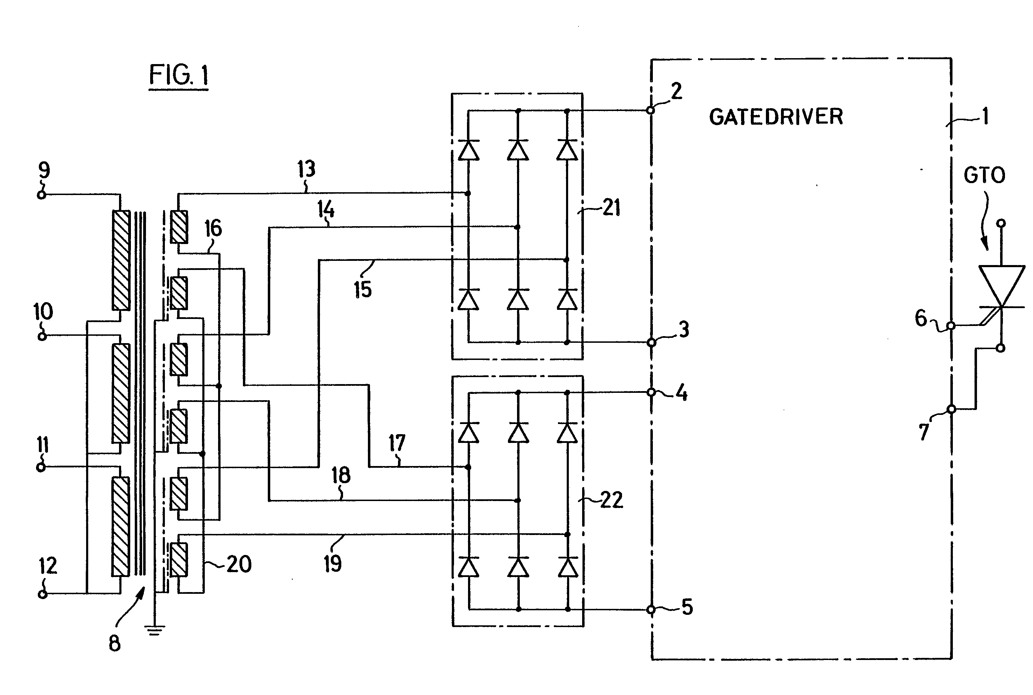

Das Blockschema von Fig. 1 zeigt die Beschaltung für einen GTO-Thyristor GTO, welche im wesentlichen aus einem Energieversorgungsteil und aus einer Ansteuerschaltung (Gatedriver) besteht. Der mit dem Bezugszeichen 1 bezeichnete Gatedriver weist darstellungsgemäss sechs Anschlüsse auf, zwei Anschlüsse 2 und 3 für die Zündgleichspannung, zwei Anschlüsse 4 und 5 für die Löschgleichspannung, einen Anschluss 6 zur Steuerelektrode und einen Anschluss 7 zur Kathode des GTO-Thyristors GTO.Der Speisetransformator des Gatedrivers 1 ist mit 8 bezeichnet. Er weist auf der Primärseite vier Anschlüsse auf, und zwar je einen Netzanschluss 9 bis 11 für jede der drei Phasen und einen Netzanschluss 12 für den Nulleiter.

Von der Sekundärseite des Speisetransformators 8 sind drei Anschlüsse 13, 14 und 15 für die drei Phasen und ein Anschluss 16 für den Sternpunkt der Zündwechselspannung sowie drei Anschlüsse 17, 18 und 19 für die drei Phasen und ein Anschluss 20 für den Sternpunkt der Löschwechselspannung abgegriffen. Die Anschlüsse 13 bis 15 für die drei Phasen der Zündwechselspannung und die Anschlüsse 17 bis 19 der Löschwechselspannung sind je an eine sechspulsige Dreiphasengleichrichterbrücke 21, 22 für die Zünd- bzw. für die Löschspannung geführt. An den Ausgängen der Gleichrichterbrücke 21 für die Zündspannung liegt die ungeglättete Zündgleichspannung (Anschlüsse 2 und 3 des Gatedrivers) und an den Ausgängen der Gleichrichterbrücke 22 für die Löschspannung liegt die ungeglättete Löschwechselspannung (Anschlüsse 4 und 5 des Gatedrivers).

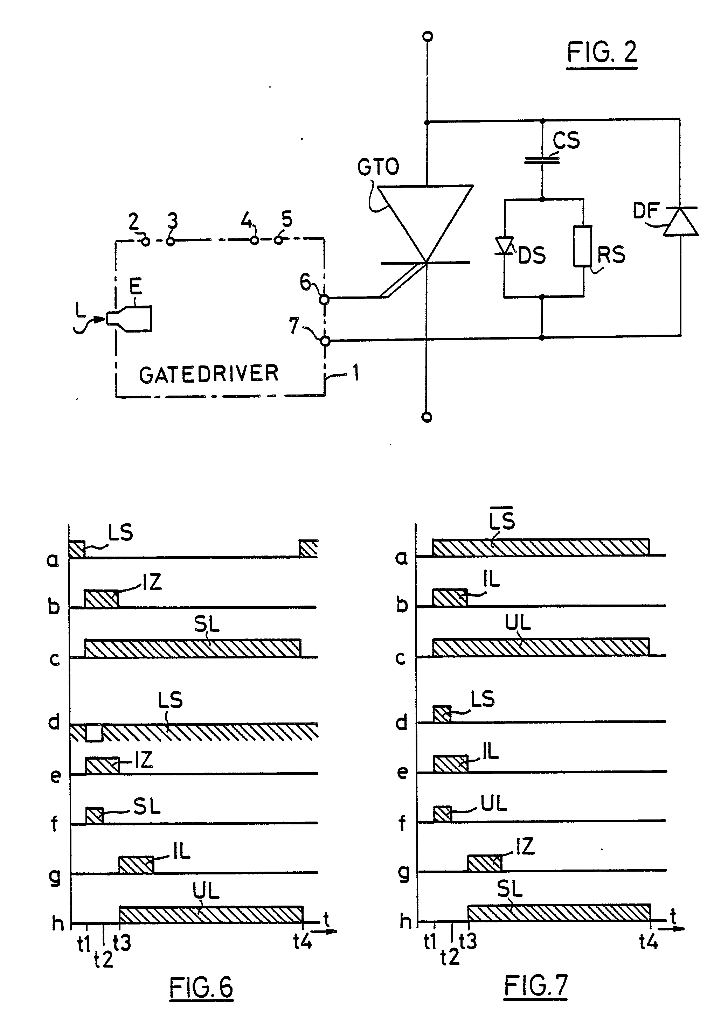

Der Gatedriver 1, der dem Steuerteil des Rundsteuersenders zuzurechnen ist, enthält ein Mikroprozessorsystem, welches für jeden Augenblick die richtige Zünd- und Löschfolge des GTO-Thyristors errechnet. Die Steuersignale des Mikroprozessorsystems werden in optische Signale umgewandelt und über Lichtleiter L (Fig. 2) an den Gatedriver weitergeleitet, welcher einen entsprechenden Empfänger E für die optischen Signale der Lichtleiter L aufweist. Der Gatedriver 1 wandelt die optischen Signale in elektrische um und stellt dem GTO-Thyristor zum richtigen Zeitpunkt die erforderlichen Steuerspannungen und -ströme zur Verfügung, so dass der Thyristor seine Funktion als Hochleistungs-Halbleiterschalter erfüllen kann.

Pro Rundsteuersender sind sechs GTO-Module vorgesehen, von denen jedes einen GTO-Thyristor samt Gatedriver gemäss Fig. 2 enthält. Diese sechs GTO- Thyristoren sind in Form von drei Paaren angeordnet und werden durch die Zündfolgen so gesteuert, dass die Knotenspannungen, das ist jeweils die Ausgangsspannung eines GTO-Paars, abgenommen zwischen den beiden GTO-Thyristoren, einem vorgegebenen Muster entsprechen. Aus diesen Knotenspannungen werden verkettete Ausgangsspannungen mit einem treppenförmigen Verlauf gebildet, welcher an einer ohmschen Last treppenförmige Phasenspannungen erzeugen.

Wenn diese von den GTO-Thyristoren erzeugten und mittels der Gatedriver angesteuerten treppenförmigen Phasenspannungen an die Hochspannungsankopplung gelegt werden, dann werden die treppenförmigen Spannungen gefiltert und der 50-Hertz-Netzfrequenz als sinusförmige Spannung mit der eingestellten Rundsteuerfrequenz überlagert. Der Sender überlagert entsprechend dem Tastung-Eingangssignal, die Tonfrequenz der Netzspannung in Form eines Bitmusters und es entsteht ein sogenanntes Telegramm, das beispielsweise bei dem bekannten DECABIT-Befehl (DECABIT eingetragenes Warenzeichen der Zellweger Uster AG) aus 11 Zeiteinheiten, einem Startimpuls, fünf weiteren Impulsen und fünf Impulslücken, besteht. Eine ganze Rundsteuersendung kann nun aus beliebig vielen Telegrammen bestehen.

Ein GTO-Thyristor kann im allgemeinen nicht mit einem Gatedriver alleine betrieben werden, sondern bedarf im praktischen Einsatz einer Schutzbeschaltung der in Fig. 2 dargestellten Art. Derartige Schutzbeschaltungen werden in der Literatur als Snubber bezeichnet und bestehen im allgemeinen aus einem RCD-Glied RS, CS, DS. Bei asymmetrisch sperrenden GTO-Thyristoren ist zusätzlich zu dieser Schutzbeschaltung noch eine antiparallele Frei laufdiode DF erforderlich.

Wenn sich der GTO-Thyristor im sperrenden Zustand befindet, dann ist der Kondensator CS auf die volle Sperrspannung des Thyristors aufgeladen. Bei einem Zündimpuls an die Steuerelektrode des GTO-Thyristors wird dessen Anoden-Kathoden-Pfad leitend und der Kondensator CS entlädt sich über den Widerstand RS mit der dafür typischen Zeitkonstanten. Erfolgt nun während dieser Entladungszeit ein Löschimpuls, dann kann die restliche Spannung über dem Kondensator CS im Anschluss an den Löschimpuls den GTO-Thyristor erneut "überkopf" zünden. Dabei kann die Verlustleistung im Halbleiterchip des GTO-Thyristors den Thyristor zerstören. Diese Gefahr der Zerstörung des GTO-Thyristors durch ein ungewolltes Wiedereinschalten (sogenanntes Retriggern) des Halbleiters wird durch eine Verriegelung des Löschimpulses für die Dauer der mehrfachen Entladungszeitkonstanten des Kondensators CS, also während der Zündimpulsdauer auf dem Gatedriver, verhindert (siehe Fig. 6).

Wenn sich der GTO-Thyristor im leitenden Zustand befindet und es erfolgt ein Löschimpuls, so müssen aufgrund des Aufbaus und der Struktur des Halbleiterchips viele einzelne Kristallbereiche in den Sperrzustand gebracht werden, um den GTO-Thyristor zu löschen. Während des Abschaltvorganges entsteht kurzzeitig eine sehr hohe Verlustleistung und somit Wärme, die vom GTO-Thyristor abgeleitet werden muss.

Erfolgt während dieser Abschaltphase ein Retriggern durch einen Zündimpuls auf der Steuerleitung oder durch ein "Ueberkopf-Zünden", so werden zusätzliche Ladungsträger in den Halbleiter injiziert, wodurch die Verlustlei- stung weiter ansteigt. Dies kann zu örtlichen Ueberhitzungen des Halbleiters und damit zur Zerstörung des GTO-Thyristors führen. Zur Vermeidung dieses unerwünschten Betriebszustandes muss deshalb ein anstehender Zündimpuls so lange gesperrt werden, bis der Löschvorgang abgeschlossen ist; erst dann darf der GTO-Thyristor neu gezündet werden. Der zeitliche Signalverlauf dieser Zündimpulsverriegelung ist in Fig. 7 dargestellt.

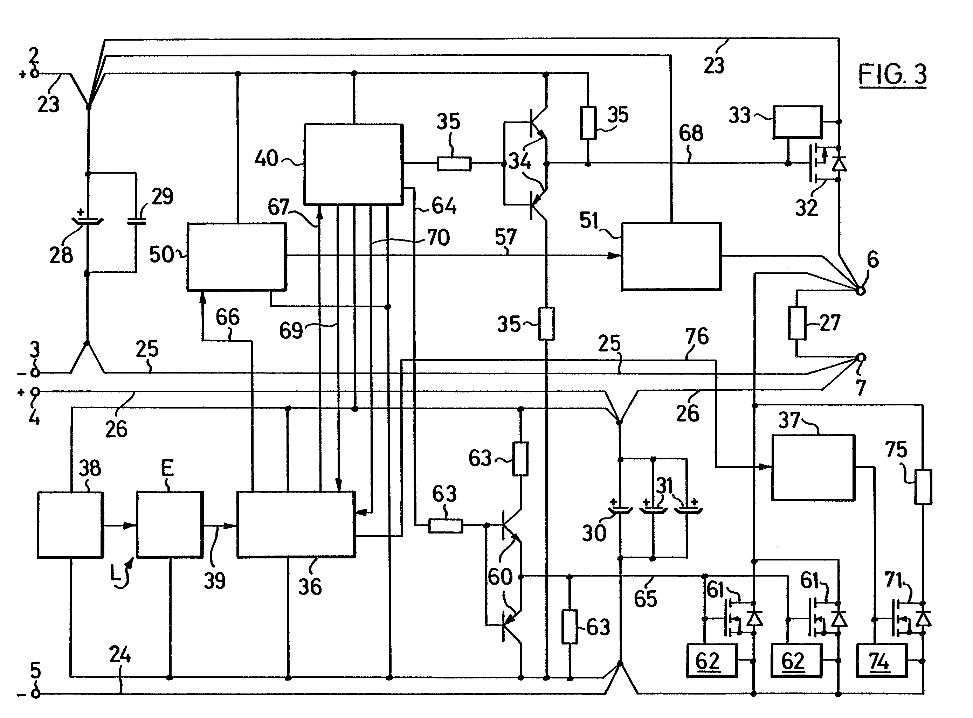

Der Gatedriver 1 ist in den Fig. 3 bis 5 im Blockschema dargestellt, wobei jedes dieser Blockschemas jeweils den gesamten Gatedriver zeigt, jedoch der Detaillierungsgrad einzelner Komponenten in den einzelnen Figuren verschieden ist. Gemäss Fig. 3 ist vom Anschluss 2 eine Plussammelschiene 23 über einen FET-Schalter 32 und vom Anschluss 5 eine Minussammelschiene 24 über einen FET-Schalter 61 an den Anschluss 6 zur Steuerelektrode des GTO-Thyristors und von den Anschlüssen 3 und 4 je eine Minus- bzw. Plussammelschiene 25 bzw. 26 an den Anschluss 7 zur Kathode des GTO-Thyristors geführt. Zwischen den beiden Anschlüssen 6 und 7 zum GTO-Thyristor ist eine Gatedriver- Abschlussbeschaltung 27 vorgesehen.

In dem von den Anschlüssen 2 und 3 abzweigenden Kreis für die Zündgleichspannung (Plus- und Minussammelschiene 23 bzw. 25) sind zwei durch Kondensatoren gebildete Zündladungsspeicher 28 und 29 angeordnet, von denen der Zündladungsspeicher 28 als Energiespeicher für den Zündimpuls und der Zündladungsspeicher 29 als Energiespeicher für eine grosse Stromflankensteilheit dient. Analog sind in dem von den Anschlüssen 4 und 5 abzweigenden Kreis für die Löschgleichspannung (Plus- und Minussammelschiene 26 bzw. 24) ein bis drei Ladungsspeicher 30, 31 für den Löschstromimpuls und für eine -hohe Stromflankensteilheit angeordnet. Die Anzahl dieser Ladungsspeicher ist von der Leistungsgrösse des GTO-Thyristors abhängig.

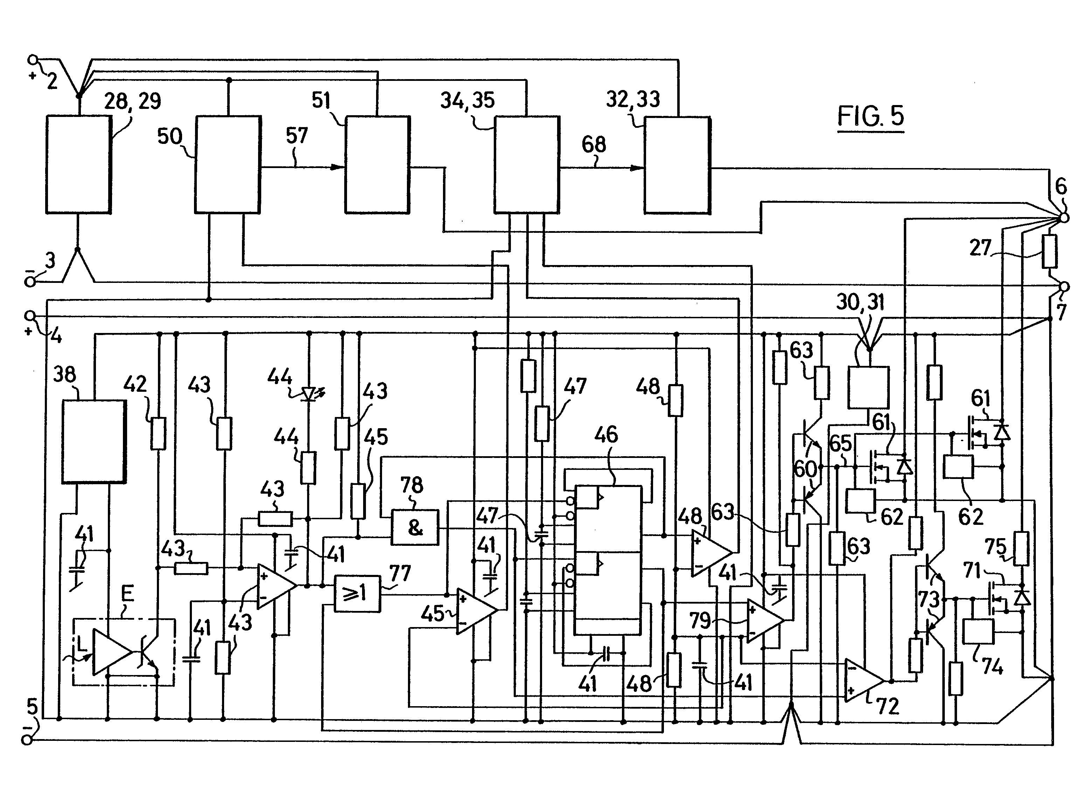

Die Auslösung des Zündimpulses für den GTO-Thyristor erfolgt durch den Leistungs-FET-Schalter (P-Kanal-FET) 32, welcher eine entsprechende Schutzbeschaltung 33 aufweist und der von einer Gegentaktstufe 34 mit Beschaltung 35 gesteuert ist. Die Gegentaktstufe 34 ist von einer Zünd- und Löschimpulslogik 40 gesteuert, welche ihrerseits an eine Signalauswertestufe 36 angeschlossen ist. Die Zünd- und Löschimpulslogik 40 ist in Fig. 5 ausführlicher dargestellt. Die Signalauswertestufe 36 ist durch den schon erwähnten Lichtempfänger E gesteuert, der von einer Speisung 38 gespeist ist und den Lichtleiteranschluss L aufweist.

Der durch eine Fiberoptik gebildete Lichtleiteranschluss L ist an eine zentrale Steuerstufe (nicht dargestellt) zur Verarbeitung der in den Rundsteuersender eingegebenen Befehle und Signale angeschlossen, welche diesen Daten entsprechende Steuerimpulse über den Lichtleiteranschluss L zum Lichtempfänger E leitet. Der letztere gibt über eine Leitung 39 entsprechende elektrische Steuersignale an die Signalauswertestufe 36 ab.

Der Lichtempfänger E wertet die Lichtinformation der Fiberoptik L so aus, dass ein Signalwechsel von kein Licht zu Licht einen Zündimpuls auslöst, welcher von einer Aufschaltung des sogenannten Latchstroms gefolgt wird, und dass ein Signalwechsel von Licht zu kein Licht (Verlöschen des Lichts) einen Löschimpuls auslöst. Anschliessend an den Löschimpuls wird die negative Gate-Kathodenspannung aufgebaut. Latchstrom bedeutet in diesem Zusam- menhang denjenigen Steuerstrom, der den GTO-Thyristor im eingeschalteten Zustand hält, und zwar auch dann, wenn der Laststrom unter den Haltestrom des GTO-Thyristors abfällt. Der Latchstrom könnte daher sinngemäss als Steuer-Haltestrom bezeichnet werden.

Wie schon erwähnt wurde, weist die Schaltung des Gatedrivers als zusätzliche Funktion eine Zündimpuls-Verriegelung auf, deren zeitlicher Verlauf in Fig. 7 dargestellt ist, wobei in den Zeilen a bis c von Fig. 7 der Normalbetrieb und in den Zeilen d bis h der Störbetrieb gezeigt ist.

Wenn im Normalbetrieb zum Zeitpunkt t1 das den Lichtempfänger E beaufschlagende Lichtsignal LS von Licht auf kein Licht wechselt (in Zeile a ist das zu LS komplementäre Signal LS quer, also kein Licht, eingezeichnet), dann wird ein Löschimpuls IL erzeugt (Zeile b) und zwischen Gate und Kathode 6 bzw. 7 wird eine Löschspannung UL aufgebaut (Zeile c), und zwar solange, bis das Lichtsignal zum Zeitpunkt t4 wieder von kein Licht auf Licht wechselt, wodurch der GTO-Thyristor gezündet wird.

Wenn der Wechsel von kein Licht auf Licht und damit der Zündimpuls schon bereits zum Zeitpunkt t2 auftritt, also zu einem Zeitpunkt, zu dem der GTO-Thyristor sperren sollte (Zeile d), dann würde die Löschspannung UL erlöschen (Zeile f) und es würde beim Erlöschen des Löschimpulses IL (Zeile e) zum Zeitpunkt t3 ein Zündimpuls IZ (Zeile g) erzeugt, und gleichzeitig der Latchstrom SL (Zeile h) aufgeschaltet und der GTO-Thyristor würde neu zünden bevor der Löschvorgang abgeschlossen ist.

Die Verriegelung des Zündimpulses IZ (Zeile g) muss dem folgenden logischen Zusammenhang gehorchen: Ein Zündimpuls darf nur dann wirksam werden, wenn kein Lichtsignal LS und kein Löschimpuls IL mehr anstehen. Das ergibt nach der Booleschen Umformung die für die Praxis anwendbare Formel:

IZ quer = LS + IL (Formel 1)

Die praktische Realisierung dieser Funktion wird später beschrieben.

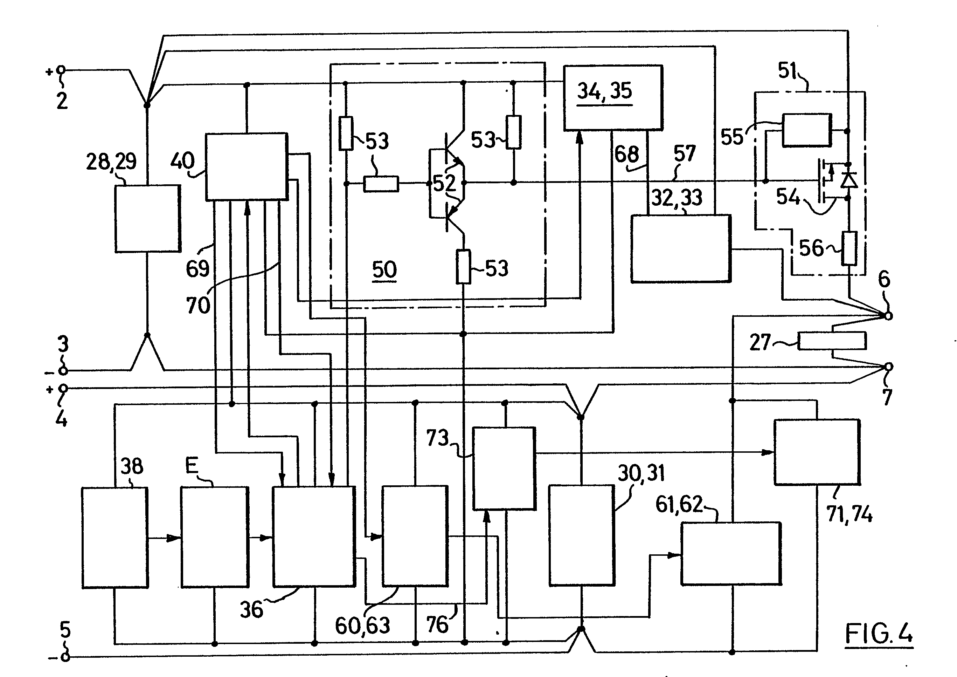

Die Signalauswertestufe 36 gibt ihre Signale an die Zünd- und Löschimpulslogik 40, an eine Ansteuerstufe 50 für den Latchstrom und an eine Ansteuerstufe 37 für die Gate-Kathoden-Sperrspannung ab, welche im wesentlichen aus einer Signallogik und einer Gegentaktstufe 73 zu einer G/K-Spannungsschaltung 71, 74 besteht. Die Ansteuerstufe 50, welche im wesentlichen eine Signallogik und eine Gegentaktstufe zum Latchstrom-Schalter aufweist, ist in Fig. 4 detaillierter dargestellt.

Wie man Fig. 3 entnehmen kann, bestehen zwischen Signalauswertestufe 36 und Zünd- und Löschimpulslogik 40 drei Verbindungsleitungen: Eine Leitung 67 für den Zündimpuls, eine Leitung 69 für die Verriegelung des Zündimpulses, und eine Leitung 70 für die Verriegelung des Löschimpulses. Ein weiterer Ausgang der Logik 40 ist über eine Leitung 64 für das Löschimpuls-Steuersignal an eine Gegentaktstufe 60 für den Löschimpulsschalter 61 geführt. Dieser ist ein Leistungs-FET-Schalter (N-Kanal-FET) für den Löschstromimpuls und weist eine entsprechende Schutzbeschaltung 62 auf. Die Beschaltung der Gegentaktstufe 60 ist mit dem Bezugszeichen 63 bezeichnet.

Die Abschalteigenschaften eines GTO-Thyristors sind unter anderem sehr stark vom Spannungsanstieg dU/dt der sich wieder aufbauenden Anoden-Kathodenspannung abhängig. Der abschaltbare Strom steht in direktem Zusammenhang mit dem Anstieg dU/dt der wiederangelegten Spannung; daraus wird deutlich, dass der GTO-Thyristor sehr empfindlich auf den im Anschluss an einen Löschimpuls erfolgenden Spannungsanstieg reagiert. Aus diesem Grund müssen Massnahmen zur Kontrolle der Anstiegsgeschwindigkeit der wiederangelegten Spannung getroffen werden.

Das dU/dt-Verhalten lässt sich einerseits durch einen kompakten Aufbau, besonders der RCD-Schutzbeschaltung (Fig. 2), und anderseits durch Verwendung einer negativen Gatespannung während der Anodenstrom-Schweifzeit wesentlich verbessern. Letzteres bedeutet, dass im Anschluss an die Abschaltung, während der ganzen Dauer der GTO-Sperrphase oder bis zum nächsten Zündimpuls, die negative Gate-Kathodenspannung beibehalten werden sollte. Diese Aufgabe wird im dargestellten Gatedriver mit der Ansteuerung eines Komparators 72, der Gegentaktstufe 73 und des G/K-Spannungsschalters 71 (Fig. 5) erfüllt. Der letzere ist ein Leistungs-FET-Schalter; seine Schutzbeschaltung ist mit 74 bezeichnet. Die Beschaltung der Gegentaktstufe 73, die aus Platzgründen nicht mit Bezugszeichen versehen ist, entspricht derjenigen der Gegentaktstufe 60. Mit dem Bezugszeichen 75 ist ein Widerstand bezeichnet, welcher zusammen mit dem G/K-Abschlusswiderstand 27 einen Spannungsteiler für den Aufbau der negativen G/K-Sperrspannung bildet. Der Widerstand 75 dient ausserdem zur Begrenzung des Kurzschlussstroms bei einem Kurzschluss an den Ausgangsklemmen 6, 7 des Gatedrivers.

Wie schon erwähnt wurde, enthält der Gatedriver als weitere zusätzliche Funktion eine Löschimpuls-Verriegelung, deren zeitlicher Verlauf in Fig. 6 dargestellt ist. Wegen der Analogie zwischen den Fig. 6 und 7 braucht Fig.6 hier nicht näher erläutert zu werden. Es sei nur darauf hingewiesen, dass in Zeile a das Lichtsignal LS, in Zeile b ein Zündimpuls IZ und in Zeile c der Latchstrom SL (jeweils für den Normalbetrieb) eingezeichnet ist. In den restlichen, den Störbetrieb betreffenden Zeilen, ist in Zeile d das Lichtsignal LS, in Zeile e ein Zündimpuls IZ, in Zeile f der Latchstrom SL, in Zeile g ein Löschimpuls IL und in Zeile h die Löschspannung Gate/Kathode eingezeichnet. Auf der Abszisse ist die Zeit t aufgetragen; dabei bezeichnet t1 den Zündmoment, t3 den Löschmoment und t2 den Zeitpunkt des Auftretens eines unerwünschten Löschimpulses.

Aus Fig. 6 ist unmittelbar ersichtlich, dass für eine Löschimpuls-Verriegelung folgender logischer Zusammenhang bestehen muss: Ein Löschimpuls IL darf nur dann auftreten, wenn kein Zündimpuls IZ mehr, oder mit anderen Worten, wenn ein negierter Zündimpuls IZ quer, anliegt, und wenn das Lichtsignal LS den Zustand logisch "1" angenommen hat, also eine Beaufschlagung mit Licht stattfindet. Das bedeutet als Formel geschrieben:

IL = IZ quer. LS (Formel 2)

Die praktische Realisierung dieser Funktion wird später beschrieben.

Ueber eine Leitung 64 liefert die Zünd- und Löschimpulslogik 40 das Steuersignal für den Löschimpuls an die Gegentaktstufe 60, welche ihrerseits über eine Leitung 65 das Steuersignal für den Löschimpulssschalter 61 abgibt. Ueber eine mit 66 bezeichnete Leitung zwischen Signalauswertestufe 36 und Ansteuerstufe 50 erhält die letztere das Steuersignal für den Latchstrom und die Zünd- und Löschimpulslogik 40 erhält das Steuersignal für den Zündimpuls über die Leitung 67. Von der Ansteuerstufe 50 führt eine mit 57 bezeichnete Leitung mit dem Steuersignal für den Latchstromschalter zu einer Latchstromschaltung 51, welche in Fig. 4 detaillierter dargestellt ist. Das Steuersignal für den Zündimpulsschalter 32 wird von der Gegentaktstufe 34 über eine Leitung 68 geliefert.

Ueber eine Leitung 76 liefert die Signalauswertestufe 36 das Steuersignal für die Gate-Kathodensperrspannung an die Ansteuerstufe 37 (Fig. 3) und somit an die Gegentaktstufe 73, welche ihrerseits den G/K-Spannungsschalter 71 steuert.

Fig. 4 zeigt ein Blockschema des Gatedrivers 1 mit einer ausführlicheren Darstellung der Ansteuerstufe 50 und der Latchstromschaltung 51. Darstellungsgemäss enthält die Ansteuerstufe 50 eine Gegentaktstufe 52 mitsamt Beschaltung 53 und die Latchstromschaltung 51 besteht aus einem Leistungs- FET-Schalter (P-Kanal-FET) 54 für den Latchstrom, aus dessen Schutzbeschaltung 55 und aus einem Widerstand 56 zur Latchstrombegrenzung.

Fig. 5 zeigt ein Blockschema des Gatedrivers 1 mit einer ausführlicheren Darstellung der Signalauswertung und der Zünd- und Löschimpulslogik 36 bzw. 40 (Fig. 3) sowie der Löschimpulsverriegelung, der Zündimpulsverriegelung und der Beschaltung der negativen G/K-Spannung während der Sperrphase des GTO-Thyristors.

Die Zünd-und Löschimpulslogik 40 enthält eine Anzahl von Abblock-Kondensatoren 41, einen Beschaltungswiderstand 42 für den Lichtempfänger E, einen Komparator mit Schmitt-Trigger-Beschaltung 43, eine optische Anzeige 44 (LED) der Lichtübertragung mit einem Beschaltungswiderstand, einen Komparator 45 für die Signalauswertung des Latchstroms, einen monostabilen Multivibrator 46 zur Erzeugung der Zündimpulsdauer, ein RC-Zeitglied 47 zur Bestimmung der Zündimpulsdauer, einen Komparator mit Schwellwertbeschaltung 48 für die Signalauswertung für die Zündimpulsdauer und einen Komparator 79 zur Ansteuerung der Gegentaktstufe 60 für den Löschimpulsschalter 61.

Die logische Funktion gemäss Formel 1 für die Zündimpulsverriegelung wird durch ein logisches Schaltglied 77 realisiert, dessen Signaleingänge durch das Ausgangssignal des Lichtempfängers E und somit durch das Lichtsignal L und durch den Zündimpuls vom monostabilen Multivibrator 46 gebildet sind. Ausgangsseitig steuert das Schaltglied 77 den Komparator 45 zur Ansteuerung des Latchstromschalters 54 (Fig. 4) sowie den monostabilen Multivibrator 46 zur Generierung des Zündimpulses.

Die logische Funktion gemäss Formel 2 für die Löschimpulsverriegelung wird durch ein logisches Schaltglied 78 realisiert, dessen Signaleingänge durch das Ausgangssignal des Lichtempfängers E und durch den negierten Zündimpuls vom monostabilen Multivibrator 46 gebildet sind. Der Ausgang des Schaltgliedes 78 steuert einerseits den monostabilen Multivibrator 46 für die Löschimpulsgenerierung und anderseits den Komparator 72 zur Ansteuerung des G/K Spannungsschalters 71, der die negative Gate-Kathodenspannung an den Steueranschlüssen 6 und 7 des GTO-Thyristors aufbaut. Die Gate-Kathoden- Sperrspannungsschaltung schliesslich ist durch die Ansteuerung des Komparators 72 und der Gegentaktstufe 73 und durch den G/K-Spannungsschalter 71 realisiert.

Abschliessend sei noch darauf hingewiesen, dass bei Verwendung von GTO-Thyristoren als Frequenzumformer für Rundsteuersender jeweils sechs derartige GTO-Thyristoren mit den zugehörigen Gate-Drivern erforderlich sind.

## Ansprüche

1. Ansteuerschaltung für einen mit hohen Taktfrequenzen betreibbaren GTO- Thyristor mit einer separaten Zünd-und Löschschaltung, dadurch gekennzeichnet, dass für die Erzeugung der Zünd- und Löschstromimpulse je ein eigener kapazitiver Ladungsspeicher (28, 29 bzw. 30, 31) vorgesehen ist, und dass die Schaltung ein direkt über eine Gegentaktstufe (34 bzw. 60) ansteuerbares schnelles Schaltelement (32 bzw. 61) enthält, welches bei seiner Ansteuerung den jeweiligen Ladungsspeicher über den Gate-Kathodenpfad (6, 7) des GTO-Thyristors (GTO) entlädt.

2. Ansteuerschaltung nach Anspruch 1, dadurch gekennzeichnet, dass jedem der beiden Ladungsspeicher (28, 29; 30, 31) für die Erzeugung der Zünd- beziehungsweise Löschstromimpulse ein schnelles Schaltelement (32 bzw. 61) zugeordnet ist, und dass diese Schaltelemente vorzugsweise durch Leistungsfeldeffekttransistoren gebildet sind.

3. Ansteuerschaltung nach Anspruch 2, dadurch gekennzeichnet, dass die Ladungsspeicher (28, 29; 30, 31) an eine Speisung (21, 22) angeschlossen sind, welche zur Erzielung einer hohen Schalthäufigkeit des GTO-Thyristors (GTO) mindestens zwei, vorzugsweise drei, gleichgerichtete Phasen des Drehstromnetzes verwendet.

4. Ansteuerschaltung nach Anspruch 2 oder 3, gekennzeichnet durch ein in der Schaltung zur Erzeugung des Zündimpulses angeordnetes weiteres Schaltelement (54) und einen strombegrenzenden Widerstand (56) zur Einspeisung eines Steuer-Haltestroms, des sogenannten Latchstroms, während der leitenden Phase des GTO-Thyristors (GTO) auf dessen Gate-Kathodenpfad.

5. Ansteuerschaltung nach Anspruch 4, dadurch gekennzeichnet, dass das weitere Schaltelement (54) durch einen Leistungsfeldeffekttransistor gebildet ist.

6. Ansteuerschaltung nach Anspruch 5, dadurch gekennzeichnet, dass der das weitere Schaltelement (54) bildende Leistungsfeldeffekttransistor durch eine Gegentaktstufe (52) angesteuert ist.

7. Ansteuerschaltung nach Anspruch 2 oder 3, dadurch gekennzeichnet, dass die dem Schaltelement (61) für die Löschstromimpulse zugeordnete Gegentaktstufe (60) von einem ersten Komparator (79) angesteuert ist, und dass die Löschschaltung eine weitere, von einem zweiten Komparator (72) angesteuerte Gegentaktstufe (73) aufweist, welcher ein Gate-Kathodenspannungsschalter (71) zur Aufrechterhaltung der negativen Gate-Kathodenspannung während der Sperrphase des GTO-Thyristors (GTO) nachgeschaltet ist.

8. Ansteuerschaltung nach Anspruch 7, gekennzeichnet durch einen zwischen dem Gate-Kathodenspannungsschalter (71) und dem Gate-Anschluss (6) an- geordneten Widerstand (75), welcher zusammen mit dem Gate-Kathoden-Abschlusswiderstand (27) einen Spannungsteiler für den Aufbau der negativen Gate-Kathodenspannung bildet.

9. Ansteuerschaltung nach. Anspruch 2, dadurch gekennzeichnet, dass die Schaltung (1) durch eine optische Signalleitung (L), vorzugsweise durch eine Faseroptik angesteuert ist und eine dieser zugeordnete optische Empfangsvorrichtung (E) zur Umwandlung der empfangenen optischen in elektrische Signale aufweist.

10. Ansteuerschaltung nach Anspruch 9, dadurch gekennzeichnet, dass die optische Empfangsvorrichtung (37) an eine Signalauswertestufe (36) angeschlossen ist, durch welche bei einem Wechsel des Empfangssignals von kein Licht auf Licht ein Zündimpuls und bei einem Signalwechsel von Licht auf kein Licht ein Löschimpuls ausgelöst wird.

11. Ansteuerschaltung nach den Ansprüchen 4 und 10, dadurch gekennzeichnet, dass der Zündimpuls von einer Aufschaltung des Latchstroms und der Löschimpuls von einem Aufbau der negativen Gate-Kathodenspannung gefolgt ist.

12. Ansteuerschaltung nach Anspruch 9, gekennzeichnet durch einen Schaltkreis zur Zündimpulsverriegelung, durch welchen ein anstehender Zündimpuls (IZ) solange gesperrt ist, bis der jeweilige Löschvorgang abgeschlossen ist, welcher Schaltkreis ein logisches Schaltglied (77) aufweist, dessen Signaleingänge durch das Ausgangssignal der optischen Empfangsvorrichtung (E) und durch den Zündimpuls des Zündimpulsgenerators (46) gebildet sind, und dessen Ausgangssignal einen Komparator (45) zur Ansteuerung des Schalters (54) für den Latchstrom und den Zündungsimpulsgenerator steuert.

13. Ansteuerschaltung nach den Ansprüchen 7 und 9, gekennzeichnet durch einen Schaltkreis zur Verriegelung eines anstehenden Löschimpulses (IL) für eine mindestens der Entladungszeitkonstanten des Kondensators (CS) der Schutzbeschaltung des GTO-Thyristors (GTO) entsprechende Dauer, welcher Schaltkreis ein logisches Schaltglied (78) aufweist, dessen Signaleingänge durch das Ausgangssignal der optischen Empfangsvorrichtung (E) und durch den negierten Zündimpuls des Zündimpulsgenerators (46) gebildet sind, und dessen Ausgangssignal den Löschimpulsgenerator (46) und den Komparator (72) zur Ansteuerung des Gate-Kathodenspannungsschalters (71) steuert.

14. Ansteuerschaltung nach den Ansprüchen 12 und 13, dadurch gekennzeichnet, dass der Zünd- und/oder der Löschimpulsgenerator durch einen monostabilen Multivibrator (46) gebildet ist.

FIG. 1
GATEDRIVER
GTO
1
2
3
4
5
6
7
8
9
10
11
12
13
14
15
16
17
18
19
20
21
22

FIG. 2
GTO
CS
DF
DS
RS
2
3
4
5
6
7
E
L
GATEDRIVER
1

LS
IZ
SL
LS
IZ
SL
IL
UL
a
b
c
d
e
f
g
h
t
t1
t2
t3
t4
FIG.6
LS
IL
UL
LS
IL
UL
IZ
SL
a
b
c
d
e
f
g
h
t
t1
t2
t3
t4
FIG.7

FIG. 3
E
L
2
3
4
5
6
7
23
24
25
26
27
28
29
30
31
32
33
34
35
36
37
38
39
40
50
51
57
60
61
62
63
64
65
66
67
68
69
70
71
74
75
76

FIG. 4

FIG. 5